(19) Europäisches Patentamt / European Patent Office / Office européen des brevets

(11) **EP 4 601 006 A1**

(12) **EUROPEAN PATENT APPLICATION**

(43) Date of publication:
**13.08.2025 Bulletin 2025/33**

(21) Application number: **25151894.0**

(22) Date of filing: **15.01.2025**

(51) International Patent Classification (IPC):
**H01L 23/522** (2006.01)   **H01L 21/78** (2006.01)
**H10D 1/68** (2025.01)

(52) Cooperative Patent Classification (CPC):
**H01L 23/5223; H01L 21/78; H10D 1/68;
H10D 1/692; H10D 1/716**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.02.2024 IN 202441009249**

(71) Applicant: **NXP B.V.**
**5656 AG Eindhoven (NL)**

(72) Inventors:
• **REBER, Douglas Michael**
**5656AG Eindhoven (NL)**
• **SHROFF, Mehul D**
**5656AG Eindhoven (NL)**
• **BHOOSHAN, Rishi**
**5656AG Eindhoven (NL)**

(74) Representative: **Colaiuda, Antonella**
**NXP Semiconductors Germany GmbH**
**Intellectual Property Group**
**Beiersdorfstraße 12**
**22529 Hamburg (DE)**

(54) **ELECTRONIC DEVICES INCLUDING A SIDEWALL STRUCTURE AND METHODS OF FORMATION THEREOF**

(57) An electronic device including a substrate having a first surface, a second surface, and one or more sidewalls. The electronic device may include a base metallization coupled to the first surface, one or more circuit layers formed on the second surface, and a dielectric layer on the one or more sidewalls and on the one or more circuit layers. The electronic device may include a metal layer formed on the dielectric layer. In some embodiments, one or more of the metal layer or the dielectric layer may form an ionic-contamination barrier. In some implementations, the metal layer, the dielectric layer, and one or more of the substrate or the base metallization layer may form a capacitor that extends around the one or more sides.

FIG. 7

## Description

### FIELD OF USE

The present disclosure generally relates to electronic devices that include a sidewall structure and methods of formation thereof.

### BACKGROUND

Semiconductor circuits may benefit from having large-area decoupling capacitors. Such capacitors may help prevent voltage drops and voltage surges and can reduce or eliminate noise on the associated power rails. In some implementations, decoupling capacitors may prevent electrical energy from transferring to a circuit from another part of a larger system. Unfortunately, decoupling capacitors formed using front-end-of-the-line (FEOL) transistors may consume vital die area or may cause an increase in the chip size. Additionally, such transistors may cause high poly and active densities compared to other circuits.

Alternatively, a decoupling capacitor can be produced in the back-end-of-the-line (BEOL) metallization, for example, as a metal-insulator-metal (MIM) capacitor. However, such MIM capacitors may cause an increase in the die area to accommodate the spacing and routing requirements.

### BRIEF DESCRIPTION OF THE DRAWINGS

The detailed description is set forth with reference to the accompanying figures. In the figures, the left-most digit of a reference number identifies the figure in which the reference number first appears. The use of the same reference numbers in different figures and in the detailed description indicates similar or identical items or features.

FIG. 1 depicts a top view of a portion of a semiconductor wafer having multiple dice, in accordance with one or more embodiments of the present disclosure.

FIG. 2 depicts a cross-sectional view of a portion of the semiconductor wafer of FIG. 1 along line 2-2, including two dice and including a scribe-lane area between the dice, in accordance with one or more embodiments of the present disclosure.

FIG. 3 depicts a cross-sectional view of the semiconductor wafer of FIG. 2 and including base metallization and a scribe-lane trench through the semiconductor substrate and into the base metallization, in accordance with one or more embodiments of the present disclosure.

FIG. 4 depicts a cross-sectional view of the semiconductor wafer of FIG. 3 and including a conformal dielectric layer on the top surfaces and sidewalls of the dice, in accordance with one or more embodiments of the present disclosure.

FIG. 5 depicts a cross-sectional view of the semiconductor wafer of FIG. 4 including a patterned dielectric and deposition of the metal-insulator-metal (MIM) top-plate metal layer, in accordance with one or more embodiments of the present disclosure.

FIG. 6 depicts a cross-sectional view of the semiconductor wafer of FIG. 5 after singulation by etching, sawing, or otherwise cutting through the MIM top-plate metal layer, the dielectric, and the base metallization, in accordance with one or more embodiments of the present disclosure.

FIG. 7 depicts a cross-sectional view of a portion of one of the dice of the semiconductor wafer of FIG. 6 and including a scribe-lane extension having a selected width, in accordance with one or more embodiments of the present disclosure.

FIG. 8 depicts a top view of a plurality of separated circuit dice with die-sidewall and scribe-lane capacitors, in accordance with one or more embodiments of the present disclosure.

FIG. 9 depicts a flow diagram of a method of forming a semiconductor die including a die-sidewall capacitor, in accordance with one or more embodiments of the present disclosure.

While embodiments are described in this disclosure by way of example, those skilled in the art will recognize that the embodiments are not limited to the examples or figures described. Rather, the figures and detailed description thereto are not intended to limit embodiments to the form disclosed, but instead the intention is to cover all modifications, equivalents, and alternatives falling within the spirit and scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

## DETAILED DESCRIPTION

Embodiments of methods and circuits are described below that include a die (or "chip") including a conformal surface dielectric layer extending around the sidewalls and optionally over the top surface of the die and including a conformal metal layer deposited on the dielectric layer. In some embodiments, the die may include an integrated "seal ring" with one or more of an internal crack-stop structure and an internal ionic-contamination barrier structure, wherein "internal" means that these structures are inset from the die sidewalls toward the center of the die. One or more of the conformal dielectric layers or the overlying metal layer on the sidewalls of the die may provide an ionic-contamination barrier layer, which may also be referred to as an ionic-contamination block structure or an ionic-contamination stopper structure. In such embodiments, the ionic-contamination barrier structure of the integrated seal ring may be omitted in lieu of the conformal surface dielectric and metal layers on the die sidewalls. In one or more embodiments, in addition or alternatively to omitting the ionic-contamination barrier structure, a crack-stop structure of the integrated seal ring may be omitted. Accordingly, the die area that would otherwise be used by the omitted structures of the integrated seal ring may be repurposed, for example, by extending the area of active circuitry of the die or the size of the die may be reduced.

In one or more embodiments, the conformal surface dielectric layer and the conformal metal layer deposited on the conformal surface dielectric layer may form portions of a metal-insulator-metal (MIM) capacitor in conjunction with one or more of the semiconductor substrate or a base metallization layer coupled to the semiconductor substrate. A MIM capacitor generally includes first and second overlapping conductive electrodes or plates that are separated by an insulator (e.g., a dielectric layer). In one or more embodiments, the MIM capacitor may extend peripherally, at least in part, around the sidewalls of the die. In some implementations, the metal layer may be coupled to a conductive pad of the die to receive an operating voltage (VDD), and the semiconductor substrate and the metallization layer may be coupled to ground or a negative voltage supply (VSS). The MIM capacitor may serve as a decoupling capacitor for a supply voltage, for various input/output interfaces, and for other purposes. In one or more embodiments, a portion of the scribe-lane (a scribe-lane extension) may remain after singulating the dice, providing a scribe-lane extension formed of the dielectric layer, the metal layer, and the base metallization layer at the bottom edge of the die. The scribe-lane extension may protrude from the sidewalls of the die and may contribute to the capacitance of the MIM capacitor.

One or more embodiments of circuits and methods are described below that use the conformal dielectric layer and the metal layer on the chip sidewalls and portions of the bottom extent of the scribe lane between dice to form the MIM capacitor, which requires no extra die area, allowing a reduction of the internal area of the die. In an example, after partial sawing of the scribe-lane between dice, a dielectric may be applied conformally to the die sidewalls and optionally over other surfaces of the die. This dielectric may be selected based on its dielectric constant (k). In one or more embodiments, a dielectric material having a dielectric constant (k) may be selected that is high relative to the dielectric constant (k) of the semiconductor substrate. In an example, the dielectric material may include one or more of tantalum nitride (TaN), hafnium oxide ($HfO_2$), aluminum oxide ($Al_2O_3$), doped tantalum pentoxide ($Ta_2O_5$), or other dielectric material that may have a higher electrical resistance than the semiconductor substrate. In some embodiments, the dielectric material may be selected to enable a capacitance of approximately seventeen (17) femtofarad per micrometer squared ($fF/\mu m^2$) or more.

In one or more embodiments, a method or process flow may begin with a processed semiconductor wafer, which may have received back-grinding processing. As used herein, the term "semiconductor wafer" refers to a semiconductor substrate with a first side upon which distinct active circuit areas are formed. Each distinct active circuit area may include an active circuit area, one or more conductive pads on a top surface, scribe-lane areas between the active circuit areas, and optionally a seal-ring structure. A base metallization layer may be applied to a second side of the semiconductor wafer. The semiconductor wafer may be partially cut through the scribe-lane areas between the active circuit areas to form scribe-lane trenches that extend between the distinct active circuit areas, through the semiconductor substrate, and partially into the base metallization layer. A dielectric material may be deposited conformally onto a top surface of each of the active circuit areas and on the sidewalls and bottom extent of the scribe-lane trenches to form a dielectric layer.

In some embodiments, the dielectric layer may be patterned to remove selected portions over the one or more conductive pads to facilitate bond-pad connections. In some embodiments, a patterned sacrificial mask may be applied over the bond pads prior to deposition of the dielectric layer. After applying the dielectric layer, the sacrificial mask may be removed to expose the conductive pads. After exposing the conductive pads, a metal layer ("top plate layer") may be deposited onto the dielectric layer and into the openings through the dielectric layer to couple to the one or more conductive bond pads. After depositing the metal layer, the scribe-lane cuts may be completed to produce individual circuit dice by etching, sawing, or otherwise cutting at the center of the scribe-lane trenches.

One or more of the conformal metal layer or the conformal dielectric layer may provide an ionic-contamination barrier structure for each die, allowing for omission of an ionic contamination barrier structure from an integrated seal ring of the die. In some embodiments, the seal ring of the die may be omitted entirely, because the metal layer and the dielectric layer may provide both the ionic-contamination barrier and crack-stop functions. In some embodiments, the dielectric layer and the metal layer may couple with a combination of the substrate semiconductor material and the base metallization layer to form a metal-insulator-metal (MIM) capacitor.

By forming a MIM capacitor along the die sidewalls and portions of the scribe-lane, a MIM capacitor may be formed as a die-perimeter extension along the perimeter of the die that is approximately half the width of the scribe-lane and the thickness of the semiconductor wafer. In one or more instances, the MIM capacitor may allow for an area reduction of the die by as much as five to ten percent (5%-10%) since an otherwise internal decoupling capacitor can be omitted from the internal area of the die. Additionally, the added sidewall covering provided by the conformal surface dielectric layer and optionally the metal layer may act as an ionic-contamination barrier, allowing the seal ring design to be shrunk to only contain a sawing crack-stop structure, when applicable. In some embodiments, the sawing crack-stop structure may be omitted in addition to or in lieu of omission of the ionic-contamination barrier structure, and the dielectric layer and the metal layer may provide sawing crack-stop functionality. In either case, the overall die size may be reduced, or this may alternatively allow for an increase in the active circuit area without increasing the size of the circuit die.

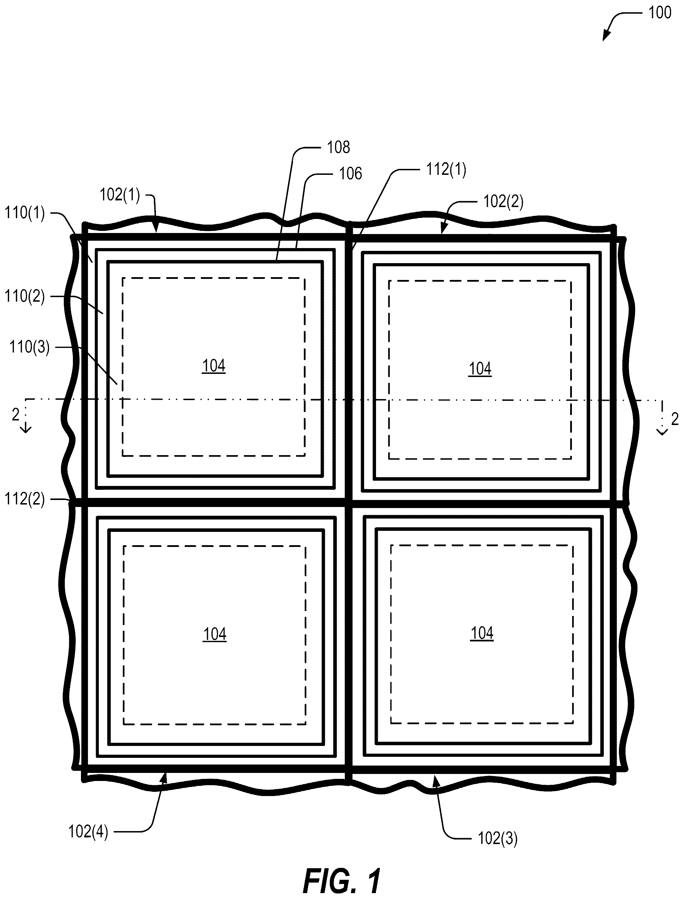

Referring now to FIG. 1, a top view of a portion a semiconductor wafer 100 is shown that includes multiple dice 102, in accordance with one or more embodiments of the present disclosure. Each die 102 may include an integrated-circuit or active-circuit area 104 and scribe-lane areas (or saw-lane areas) 112(1) and 112(2) between adjacent dice 102. The scribe-lane areas 112 may be areas of the semiconductor wafer 100 that do not include circuit structures or metal layers and that are reserved for cutting operations, such as by a saw, a laser, or other cutting process to singulate or separate the dice 102 from one another.

To prevent or reduce the likelihood of cracking of the dice 102 during the separation process, each die 102 may include a seal ring with a crack-stop structure 106, which may be formed near the periphery of the die 102 and between the scribe-lane areas 112 and the active circuit area 104 of each die 102. To prevent ionic contamination of the die 102, the seal ring may also include an ionic-contamination barrier structure 108 formed between the crack-stop structure 106 and the active circuit area 104 of the die 102. Both the crack-stop structure 106 and the ionic-contamination barrier structure 108 may contribute to the overall size of the die 102.

The die 102 may include a first buffer area 110(1) between and the scribe-lane areas 112 and the crack-stop structure 106. The die 102 may include a second buffer area 110(2) between the crack-stop structure 106 and the ionic-contamination barrier structure 108. The die 102 may include a third buffer area 110(3) between the ionic-contamination barrier structure 108 and the active circuit area 104. The crack-stop structure 106, the ionic-contamination barrier structure 108, and the buffer areas 110 contribute to the overall size of the die 102.

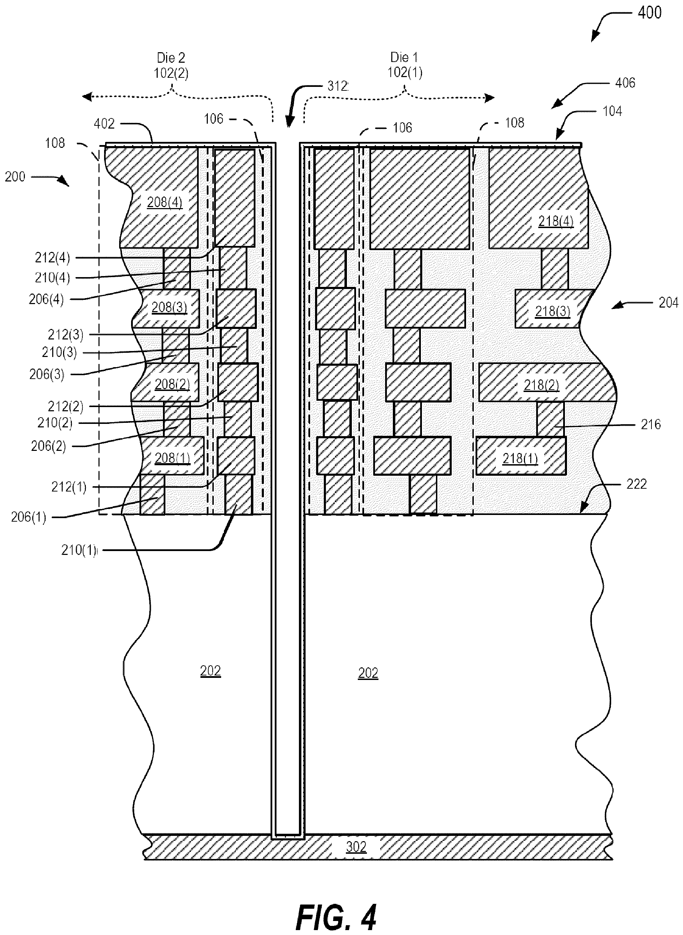

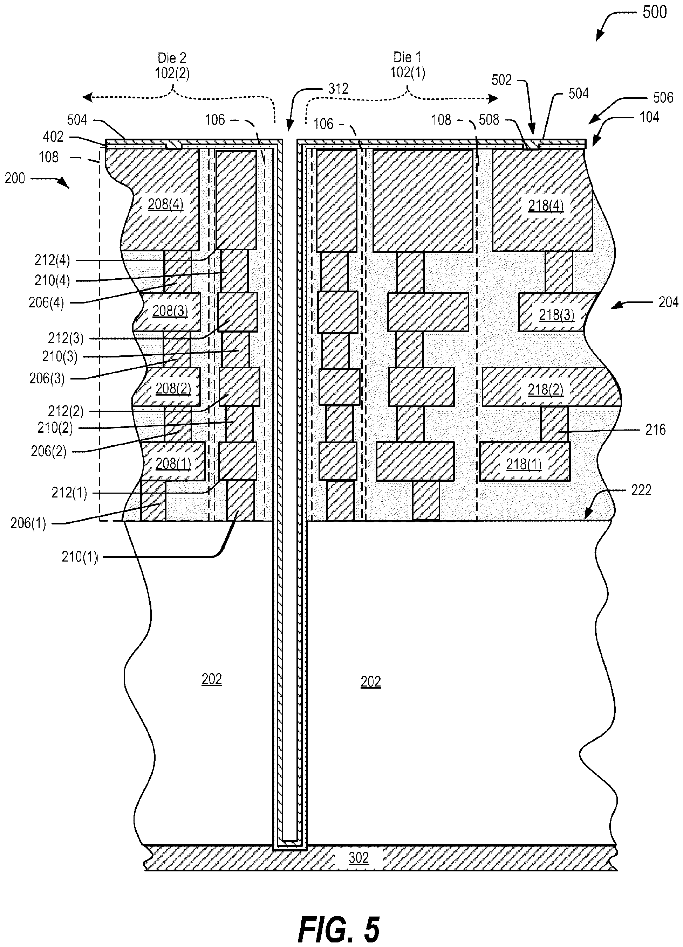

As mentioned above, embodiments of the circuits and methods described herein include a surface dielectric layer deposited conformally on the top surfaces and on the sidewalls of each die 102, forming a portion of a perimeter structure (shown in FIGs. 4-8). Additionally, a metal layer may be deposited on the surface dielectric layer, forming the perimeter structure (shown and described with respect to FIGs. 5-8). The surface dielectric layer and the metal layer may be conformal to the top surfaces and sidewalls of the die 102. The conformal metal layer and the conformal dielectric layer may operate to provide an ionic-contamination barrier function, allowing for omission of the ionic-contamination barrier structures 108, which can enable an overall reduction in the size of the die 102. In some embodiments, the dielectric layer and the metal layer may also provide a crack-stop function, allowing for omission of the crack-stop structure 106, which can enable a further reduction in the size of the die 102. Moreover, in one or more embodiments, the metal layer, the dielectric layer, and one or more of the semiconductor substrate or the base metallization layer may form a capacitor, which consumes no extra die area, allowing an internal capacitor (such as a decoupling capacitor) to be excluded and, thus, enabling internal die areas to be smaller (such as five to ten percent (5-10%) smaller).

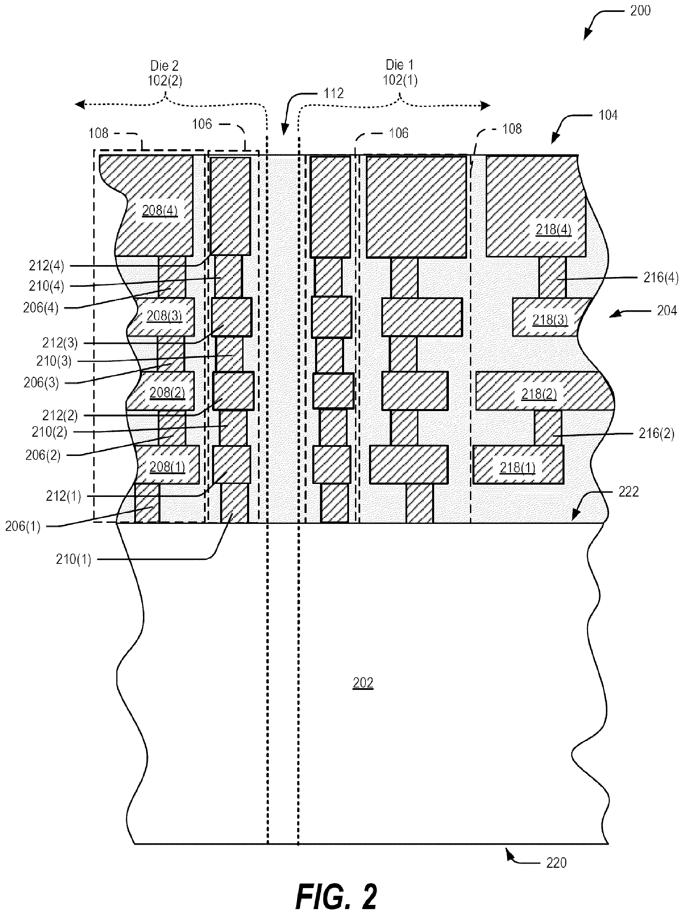

In the following discussion of FIGs. 2-7, embodiments of a process for producing one or more dice 102 with a perimeter structure is shown and described. By applying metal and dielectric layers along the sidewalls of the die, the metal layer and the dielectric layer may couple with a bottom electrode that is formed by one or more of the semiconductor substrate and the base metallization layer attached to and configured to form the bottom surface of the semiconductor substrate. The semiconductor substrate and the base metallization layer may be grounded and may form a bottom plate of a capacitor (such as a decoupling capacitor that includes the bottom plate, the conformal dielectric layer, and the conformal metal layer). The semiconductor substrate and the base metallization layer may be coupled to electrical ground or to a negative supply voltage (VSS). For plasma-diced dice, it may be possible to completely forgo the area designated for the seal ring and to rely solely on the dielectric layer and the metal layer to provide the functionality of both a crack-stop structure and an ionic-contamination barrier structure, enabling a reduced die size, an increased active circuit area, or both.

Referring now to FIG. 2, a cross-sectional view of an embodiment of a portion of a semiconductor wafer 200 is shown that may include a semiconductor substrate 202 and multiple layers 204 formed thereon that may include multiple active circuit areas 104 separated by scribe lane areas 112. In this example, the semiconductor wafer 100 may be formed and fully processed. In one or more embodiments, the semiconductor wafer 200 may have received back-grinding to define a bottom surface of the semiconductor substrate 202 and the semiconductor wafer 200. In addition, a build-up structure that includes a plurality of patterned metal layers 204 separated by dielectric layers (not numbered) is formed on the upper surface 222 of the semiconductor substrate 202. An upper surface of the build-up structure may define a top surface of the semiconductor wafer 200, and the semiconductor wafer 200 may or may not have electrical contact pads on the top surface. The semiconductor wafer 200 is provided for illustrative purposes only and is not necessarily drawn to scale.

Depending on the embodiment, the semiconductor substrate 202 may be thinner or thicker, and the build-up structure that includes the patterned metal layers 204 may be thicker or thinner and may include more or fewer layers. In some embodiments, the semiconductor substrate 202 may be formed from silicon, silicon carbide, gallium nitride, gallium arsenide, or another substrate material and may or may not include an insulative layer (e.g., silicon-on-insulator).

In the illustrated example, the semiconductor wafer 200 is provided that includes a plurality of distinct active circuit areas 104 separated by scribe-lane areas 112. The semiconductor wafer 200 may be fully processed, but the active circuit areas 104 are not yet cut from the semiconductor wafer 200 by one or more cutting operations for forming the individual dice 102. In this example, adjacent portions of only two dice 102(1) and 102(2) are shown, but it should be appreciated that the fully processed semiconductor wafer 200 may support any number of active circuit areas 104 formed in an array on the semiconductor substrate 202 prior to the cutting or singulation operations.

In the illustrated example, prior to singulation, the semiconductor wafer 200 may include a plurality of dice 102, each of which may include a seal ring including a crack-stop structure 106 and an ionic-contamination barrier structure 108. Each die 102 may be separated from adjacent dice 102 by saw-lane or scribe-lane areas 112 that extend around the crack-stop structures 106 and the ionic-contamination barrier structures 108.

In the illustrated example, each of the crack-stop structure 106 and the ionic-contamination barrier structure 108 is generally indicated by a rectangle having dashed lines in FIGs. 2-7. The crack-stop structure 106 may be comprised of first portions of metal layers 208 and contact or via structures 206 that extend between and couple the first portions of the metal layers 208 to form a structure configured to prevent or reduce the likelihood of the die 102 cracking when the semiconductor wafer 200 is cut in the scribe-lane areas 112. The ionic-contamination barrier structures 108 may be comprised of second portions of metal layers 212 and contact or via structures 210 that extend between and couple the second portions of the metal layers 212 to form a structure configured to protect the die from contamination. In the illustrated example, only the metal layers 208 and 212 and the metal structures 206 and 210 of the second die 102(2) are provided with reference numbers, though the first die 102(1) includes similar crack-stop structures 106 and ionic-contamination barrier structures 108.

Each die 102 may include an active circuit area 104, which may include various portions of metal layers 218, vias 216, and other circuit structures. In the illustrated example, the second die 102(2) is cut off such that the associated active circuit area 104 is not visible in the drawing. Typically, each die 102 may include buffer areas 110 (in FIG. 1, for example) formed from dielectric material, and which do not include internal metal or circuit structures. Such buffer areas may be located between the scribe-lane areas 112 and the crack-stop structure 106, between the crack-stop structure 106 and the ionic-contamination barrier structure 108, and between the ionic-contamination barrier structure 108 and the active circuit area 104.

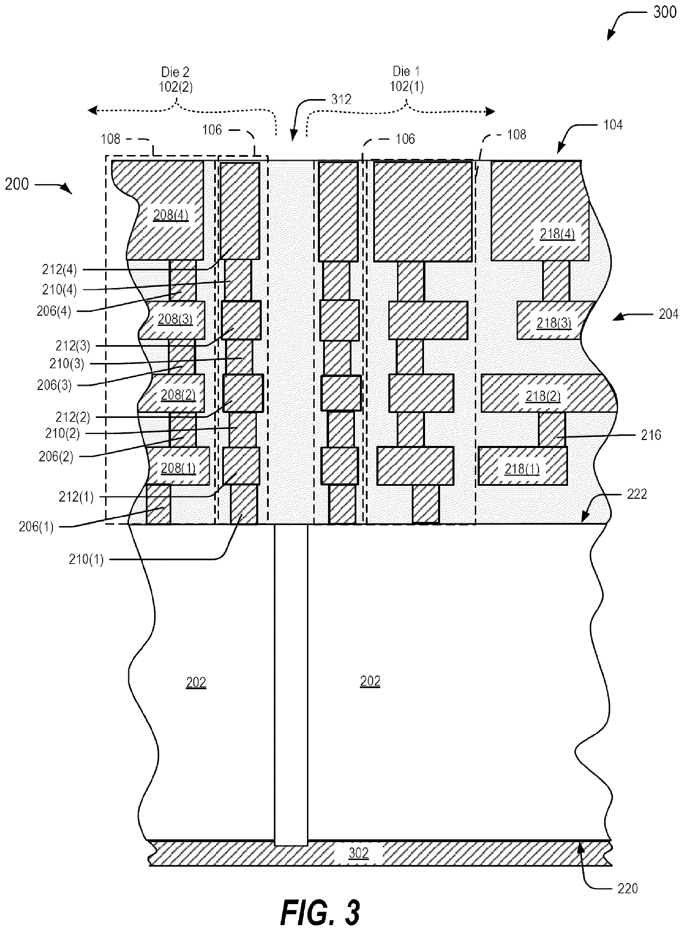

In the illustrated example, the semiconductor substrate 202 may include a first surface 220 and a second surface 222. As discussed below with respect to FIG. 3, a base metallization layer may be coupled to the first surface 220. As shown, a build-up structure of multiple conductive layers (circuit layers) 204 and dielectric layers (not numbered) may be formed on or coupled to the second surface 222 of the semiconductor substrate 202.

Referring now to FIG. 3, a cross-sectional view 300 of the semiconductor wafer 200 of FIG. 2 is shown that includes a base metallization layer 302 and a scribe-lane trench 312 extending through the scribe-lane area 112, including through the build-up structure and the semiconductor substrate 202, and partially into the base metallization layer 302, in accordance with one or more embodiments of the present disclosure. In one or more embodiments, the base metallization layer 302 may be formed from one or more of aluminum, copper, cobalt, nickel, tungsten, other conductive metals, or any combination thereof.

In this example, the base metallization layer 302 may be coupled to the first surface 220 of the semiconductor substrate 202 with conductive through-substrate vias (not illustrated). The base metallization layer 302 may be ohmic to the wafer and may therefore act as a negative voltage supply (VSS) or ground connection. This connection may be electrically and mechanically connected to the packaging, which may be grounded. The base metallization layer 302 together with the semiconductor substrate 202 may couple to form a bottom plate of a capacitor.

In the fabrication process, the active circuit areas 104 and the structures of the seal ring (if included) are formed, and the base metallization layer 302 may be applied to the semiconductor wafer 200. The semiconductor wafer 200 may then be oriented with the base metallization layer 302 down, and the semiconductor wafer 200 may be partially cut through the scribe-lane areas 112 until a small portion of the base metallization layer 302 is exposed and cut, forming scribe-lane trenches 312. In a manufacturing process that uses a saw blade for the singulation process, the saw blade may cut the semiconductor wafer 200 in the scribe-lane areas 112 through the build-up structure and the semiconductor substrate 202 and into the base metallization layer 302, such that the saw blade slightly exposes and slightly cuts the base metallization layer 302 to produce scribe-lane trenches 312. Saw blades used for cutting semiconductor wafers 200 may vary in width. In some embodiments, the saw blade may have a width of between twenty (20) and fifty (50) micrometers ($\mu$m) but may be matched to the width of the scribe-lane area 112. Alternatively, a plasma cutting tool may be used to cut through the build-up structure and the semiconductor substrate 202 within the scribe-lane areas 112, and slightly into the base metallization layer 302 to produce the scribe-lane trench 312.

The scribe-lane areas 112 may be cut, forming scribe-lane trenches 312. Each scribe-lane trench 312 may extend from a top surface of the semiconductor wafer to and partially into the base metallization layer 302. The sidewalls of the scribe-lane trenches 312 may form the die edges in the scribe-lane areas 112. As discussed below with respect to FIG. 4, the fabrication process may continue with depositing a selected dielectric onto the sidewalls of the scribe-lane trenches 312 and optionally over a top surface of the die 102 to provide a conformal dielectric layer.

Referring now to FIG. 4, a cross-sectional view 400 of the semiconductor wafer 200 of FIG. 3 is depicted that includes a conformal dielectric layer 402 extending over the top of the chip and on the sidewalls (die edges within the scribe-lane trenches 312) of the dice 102, in accordance with one or more embodiments of the present disclosure. The dielectric material may be deposited onto the substantially vertical sidewalls of the scribe-lane trenches 312, onto the horizontal surface of the partially cut base metallization layer 302 within the scribe-lane trenches 312, and on top surfaces of the etched semiconductor wafer 200 to form the conformal dielectric layer 402. The resulting semiconductor wafer is generally indicated at 406, in part, because the thickness of the dielectric layer 402 alters the thickness of the semiconductor wafer 200.

In one or more embodiments, the conformal dielectric layer 402 may be formed using atomic layer deposition (ALD), which is well suited to forming thin conformal layers, and/or using a different deposition method (e.g., low pressure chemical vapor deposition (LPCVD), sputtering, physical vapor deposition (PVD), plasma-enhanced chemical vapor deposition (PECVD), metal organic CVD (MOCVD), molecular beam epitaxy (MBE), inductively coupled plasma (ICP) deposition, electron cyclotron resonance (ECR) deposition, plasma enhanced ALD (PEALD), or other suitable techniques). In some embodiments, the conformal dielectric layer 402 may have a thickness in a range of about 50 angstroms to about 300 angstroms, though layer 402 may be thick or thinner, as well. In one or more embodiments, the dielectric layer 402 may be formed from a dielectric material that is selected to have a relatively high dielectric constant (k). In an example, the dielectric material may include one or more of tantalum nitride (TaN), hafnium oxide ($HfO_2$), aluminum oxide ($Al_2O_3$), doped tantalum pentoxide ($Ta_2O_5$), silicon nitride ($Si_3N_4$, including silicon-rich or silicon-poor compositions thereof), or another dielectric material that may be configured to enable a capacitance of approximately seventeen (17) femtofarad per micrometer squared ($fF/\mu m^2$) or more. As previously discussed, one or more of the metallization layer 302 and the semiconductor substrate 202 may form the bottom plate of a metal-insulator-metal (MIM) capacitor, while the dielectric layer 402 may form the insulator portion.

In one or more embodiments, the deposition of the dielectric layer 402 may provide an additional benefit. In particular, the dielectric layer 402 may operate to seal the die 102 from ionic and other contaminants. In some embodiments, the dielectric layer 402 may render the ionic-contamination barrier structures 108 redundant. In such a case, the ionic-contamination barrier structures 108 may be omitted, allowing room for increasing the active circuit area 104 without increasing the size of the die 102 or allowing for an overall reduction in the size of the die 102. For example, the area of the die 102 that is currently occupied by the ionic-contamination barrier structures 108 and the buffer area 110(3) (in FIG. 1) between the ionic-contamination barrier structures 108 and the active circuit area 104 may be reclaimed to either shrink the size of the die 102 or to expand the active circuit area 104 without increasing the size of the die 102.

In one or more embodiments, the fabrication process may include applying a mask over horizontal portions of the dielectric layer 402 over the top surface of the die 102, patterning the mask to include openings over selected portions of the dielectric layer 402 that cover electrical contacts or pads, removing the selected portions of the dielectric layer 402 (for example, to expose the electrical contacts or pads), and depositing a metal layer onto the dielectric layer 402 and onto the electrical contacts or pads that were exposed by patterning and etching of the dielectric layer 402. An example depicting such patterning and deposition of the metal layer is described below with respect to FIG. 5.

FIG. 5 depicts a cross-sectional view 500 of the semiconductor wafer 406 of FIG. 4 including a patterned dielectric layer 402 and deposition of a metal-insulator-metal (MIM) top-plate metal layer 504, in accordance with one or more embodiments of the present disclosure. In this example, the fabrication process may include patterning the dielectric layer 402. For example, a mask may be applied to the dielectric layer 402 and unmasked portions of the dielectric layer 402 may be etched to remove selected portions of the dielectric layer 402, such as in the contact areas 502, which may correspond to areas that include metal contacts 508 (bond pads or other electrical interconnects) on the dice 102(1) and 102(2). The patterning and etching of the dielectric layer 402 may expose one or more metal contacts or pads. Alternatively, a patterned sacrificial mask may be applied over the contact areas 502 prior to deposition of the dielectric layer 402. After applying the dielectric layer 402, the sacrificial mask may be removed to expose the conductive pads in the contact areas 502.

After exposing the contact areas 502 (if any), a metal layer 504 may then be deposited over the horizontal and vertical portions of the dielectric layer 402, within the scribe-lane trenches 312, over the top surface of the die 102, and within the contact areas 502. The metal layer 504 may form a top plate of capacitor and may be coupled to metal contacts on the die 102 at the contact area 502. The resulting semiconductor wafer is generally indicated at 506, in part, because the thickness of the metal layer 504 alters the thickness of the semiconductor wafer 406.

In some embodiments, the metal layer 504 may be applied using atomic layer deposition (ALD), which is well suited to forming thin conformal layers, and/or using a different deposition method (e.g., low pressure chemical vapor deposition (LPCVD), sputtering, physical vapor deposition (PVD), plasma-enhanced chemical vapor deposition (PECVD), metal organic CVD (MOCVD), molecular beam epitaxy (MBE), inductively coupled plasma (ICP) deposition, electron cyclotron resonance (ECR) deposition, plasma enhanced ALD (PEALD), or other suitable techniques). In some embodiments, the metal layer 504 may have a thickness in a range of about 50 angstroms to about 300 angstroms, though the metal layer 504 may be thick or thinner, as well.

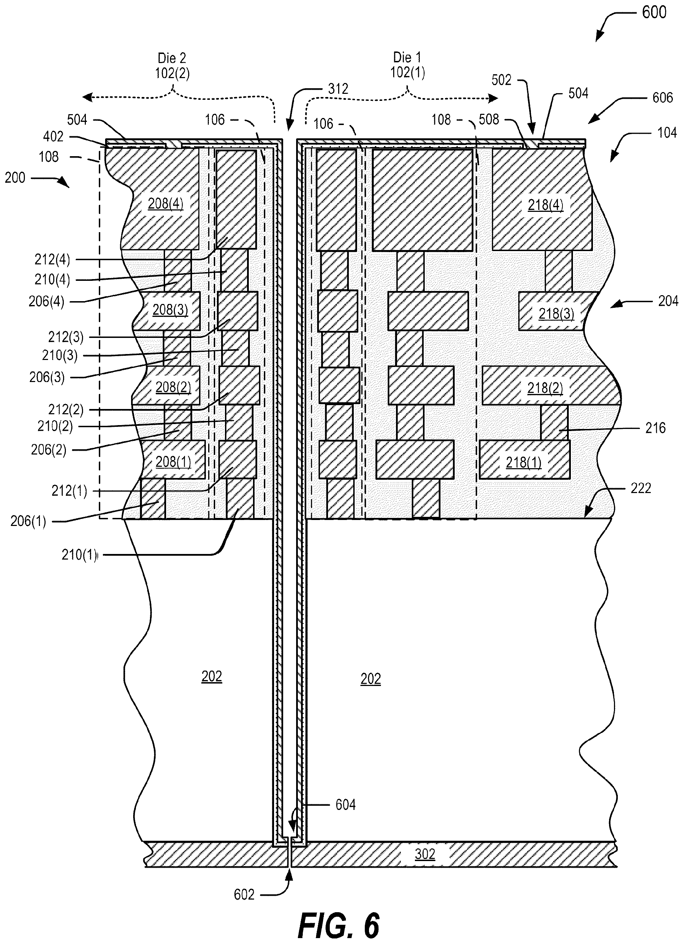

After the metal layer 504 is deposited, the fabrication process may include a singulation process, which may include completing the cut-through within the scribe-lane trenches 312 to separate the dice 102. The singulation process may be performed by etching, sawing, or otherwise cutting the semiconductor wafer 506 beginning from a side corresponding to the base metallization layer 302. The singulation process may cut through portions of the base metallization layer 302, the dielectric layer 402, and the metal layer 504 at the bottom extents of the scribe-lane trenches 312 to separate the dice 102. When a width of the cut-through (cut-through 602 in FIG. 6) is narrower than a width of the scribe-lane trench 312, the singulation process may result in a capacitor with a perimeter extension around the die 102 (e.g., a scribe-lane extension or ledge that extends outward from a bottom surface of the die 102 around the die perimeter). The perimeter extensions (scribe-lane extensions 604 in FIG. 6) may have horizontal dimensions that extend from the die sidewalls up to approximately half of the width of the scribe-lane trench 312 and that are approximately the thickness of the semiconductor wafer 202.

In some embodiments, the saw blade used to cut the scribe-lane trench 312 may have a width of twenty (20) and fifty (50) micrometers ($\mu$m) or could be sized according to a width of the scribe-lane areas 112. In this example, the saw blade used to perform the singulation process could have a width of 20um, which is smaller than the width of the scribe-lane trench 312. The saw blade can be this small, in part, because the saw blade will not be cutting the back-end of the line (BEOL) metallization, there should be little variation in the content of the material to be cut that might cause chipping and peeling.

In an alternative process, the scribe-lane trench 312 may be formed by a laser grooving operation. In this alternative approach, laser ablation could be used to singulate the dice 102. In still other embodiments, the scribe-lane trench 312 may be formed using a saw blade, and the singulation operation may be performed using a laser. Other implementations are also possible.

In one or more embodiments, the singulation operation may be completed by cutting at a center of a bottom extent of the scribe-lane trench 312. In some embodiments, the scribe-lane trench 312 may have a width that is within a range of about fifty (50) to about one hundred (100) micrometers ($\mu$m). In other embodiments, the scribe-lane trench 312 may have a width that is larger than one hundred micrometers (100$\mu$m). In one or more embodiments, the cutting operation may be completed with a cut width that is less than a width of the scribe-lane trench 312. In an example, the cut width may be twenty micrometers (20$\mu$m). The cut operation may be performed at a center of a bottom extent of each scribe-lane trench 312, leaving a remainder (a scribe lane extension 604 in FIG. 6) on either side of the cut. This remainder may include a portion of the metal layer 504, a portion of the dielectric layer 402, and a portion of the base metallization layer 302, thus extending the area of the capacitor.

FIG. 6 depicts a cross-sectional view 600 of the semiconductor wafer 506 of FIG. 5 after singulation by etching, sawing, or otherwise cutting through a portion of the metal layer 504, a portion of the dielectric layer 402, and portion of the base metallization layer 302 at a center of the bottom extent of the scribe-lane trench 312, in accordance with one or more embodiments of the present disclosure. The dice 102 may be separated by a sawing operation, a laser operation, or another cutting operation, providing a cut-through generally indicated at 602, which may divide the bottom extent of the scribe-lane trench 312 approximately in half.

As indicated above, it may be desirable to provide as small a cut as possible, while dividing the scribe-lane trench 312 in half to leave a remainder (a scribe-lane extension 604) on each side. The scribe-lane extension 604 may contribute to the surface area of the capacitor. The scribe-lane trench 312 (in FIG. 3) may have a width that may vary from approximately sixty (60) to about two hundred (200) micrometers ($\mu$m), depending on the embodiment. Depending on the width of the scribe-lane trench 312 and the width of the cut-through 602 at the center of the scribe-lane trench 312, the scribe-lane extension 604 may have a width of about forty (40) to about one hundred

(100) micrometers ($\mu$m). The scribe-lane extensions 604 may be formed at a bottom of each sidewall of the die 102 and may contribute additional surface area for calculating the capacitance value of the capacitor.

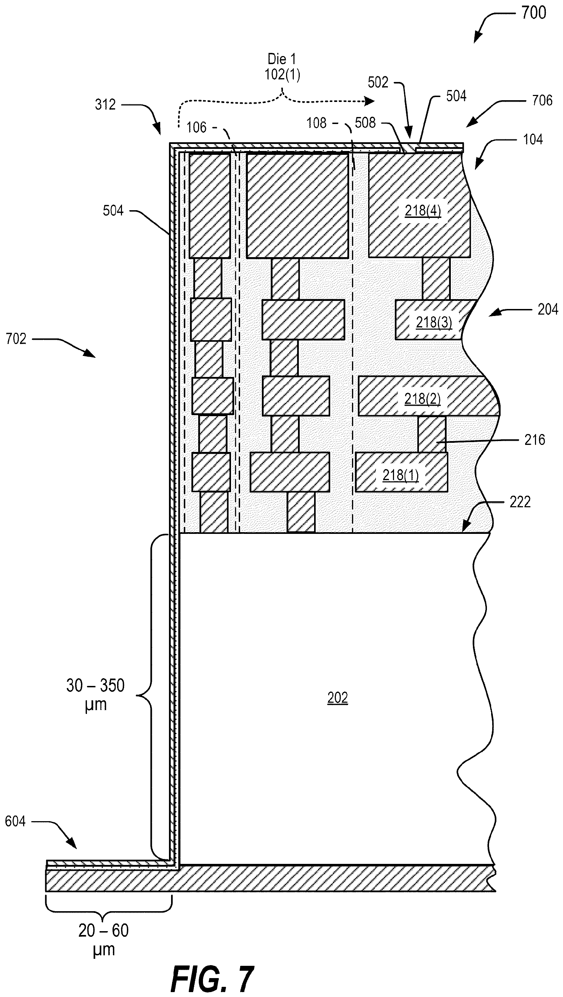

Referring now to FIG. 7, a cross-sectional view of a portion of the first die 102(1) of the semiconductor wafer 506 of FIG. 6 is shown that includes a scribe-lane extension 604 having a selected size, in accordance with one or more embodiments of the present disclosure. In this example, the first die 102(1) has been cut from the semiconductor wafer 506, producing one or more sidewalls 702. The sidewall 702 is covered with a conformal dielectric layer 402 and a conformal metal layer 504, which may provide the functionality of a seal ring that may provide a crack-stop and an ionic-contamination barrier. Additionally, the conformal dielectric layer 402 and the conformal metal layer 504 may provide a metal-insulator perimeter extension that may couple with one or more of the semiconductor substrate 202 or the base metallization layer 302 to form the capacitor.

As mentioned above, the width of the scribe-lane extension 604 may contribute to the overall capacitance of a MIM capacitor. For a 1 millimeter (mm) x 1 mm die 102 that has a square shape with a scribe-lane width of about sixty micrometers (60μm) and a thickness of the semiconductor substrate 202 of approximately three hundred micrometers (300μm), the MIM capacitor may have an area determined by subtracting the area of the 1mm x 1mm die 102 from the total area of the chip as follows:

$$\text{Capacitor Area} = \text{Chip Area} - \text{Die Area} + \text{Sidewall Surface Area}$$

$$(1)$$

This equation may be rewritten numerically using the values provided above as follows in Equation 2 below:

$$((1.040mm)^2 - (1mm)^2) + 4 * (0.3mm * 1mm) = 1.2816mm^2$$

$$(2)$$

In Equation 2, the example assumes that the width of the retained scribe-lane extension 604 is approximately twenty micrometers (20μm) after cutting a 60μm-wide scribe-lane 312 and assuming that a center portion that is about twenty micrometers (20μm) wide is removed during the cutting operation.

The capacitor area refers to the area in which the plates of the MIM capacitor overlap. The capacitance C associated with the MIM capacitor is a function of the capacitor area (A) as follows:

$$C = \frac{k\varepsilon_0 A}{d}$$

$$(3)$$

where C is the capacitance measured in farads (F), $\varepsilon_0$ is the permittivity of free space (a measure of resistance encountered when forming an electric field in a vacuum), k is the dielectric constant of the material of the dielectric layer 402, A is the area where the plates overlap, and *d* is the separation distance between the plates (separation distance between the metal layer 504 and one of the semiconductor substrate 202 (the portion of the semiconductor substrate 202 including the sidewalls 702) or the metallization layer 302 (portion including the scribe-lane extension 604)).

It should be appreciated that the size of the MIM capacitor may vary with the size of the die 102. In an example that includes a 5mm x 5mm die 102 and using similar scribe-lane width and die-saw consumption of scribe lane as in equation (2), the area of the MIM decoupling capacitor may be calculated as follows:

$$((5.040mm)^2 - (5mm)^2) + 4 * (0.3mm * 5mm) = 6.4016mm^2$$

$$(4)$$

The top plate formed by the metal layer 504 may contact exposed metal on the top of the die 102, a through-hole or surface-mount pad on the top surface, or another designated connection for the MIM capacitor. In one or more embodiments, the metal layer 504 may be coupled to an operating voltage (VDD) of the die 102.

In general, the sidewall and perimeter configuration of the MIM capacitor, using the sidewalls 702 adjacent to the semiconductor wafer 202 and the metallization layer 302 and the scribe-lane extension 604 adjacent to the metallization layer 302, can be used to provide decoupling for input/output high-speed interfaces, reducing the overall die area typically reserved for such high-speed interfaces. In one or more embodiments, the MIM capacitor may be used for core power supply (0.8V, 1.1V, and so on) to reduce power-supply noise.

In one or more embodiments, the MIM capacitor may reduce the size of the die 102 by five to ten percent (5-10%) as compared to the size of a conventional die that includes a decoupling capacitor of similar capacitive density (on an order of seventeen (17) nano-farads per millimeter squared (nF/mm$^2$) or seventeen (17) femtofarads per micrometer squared (fF/μm$^2$)). Further, by moving the MIM capacitor to the sidewalls 702 and perimeter the die 102, the structure of the MIM capacitor may render ionic-contamination barrier structures 108 redundant, since the metal layer 504 and the dielectric layer 402 may also prevent ionic contamination of the die 102. Accordingly, ionic-contamination barrier structures 108 may be reduced in size or eliminated, and any buffer space (110 in FIG. 1) between the ionic-contamination barrier structures 108 and the active circuit area 104 may be reclaimed by either reducing the size of the die 102, expanding the active circuit area 104, or both.

In some manufacturing processes, cracking of the chip may be reduced or eliminated by using lasers or other cutting processes that do not cause chipping or cracking of the chip edge during singulation. In such processes, the die 102 may be produced without either of the ionic-contamination barrier structure 108 or the crack-stop structure 106, and the MIM capacitor may protect the chip both from cracking and from ionic contamination. By moving the MIM capacitor to the sidewalls 702 and perimeter the die 102, one or more of the crack-stop structure 106 and the ionic-contamination barrier structure 108 may be reduced in size or eliminated and any buffer space (110 in FIG. 1) may be reclaimed by either reducing the size of the die 102, expanding the active circuit area 104, or both.

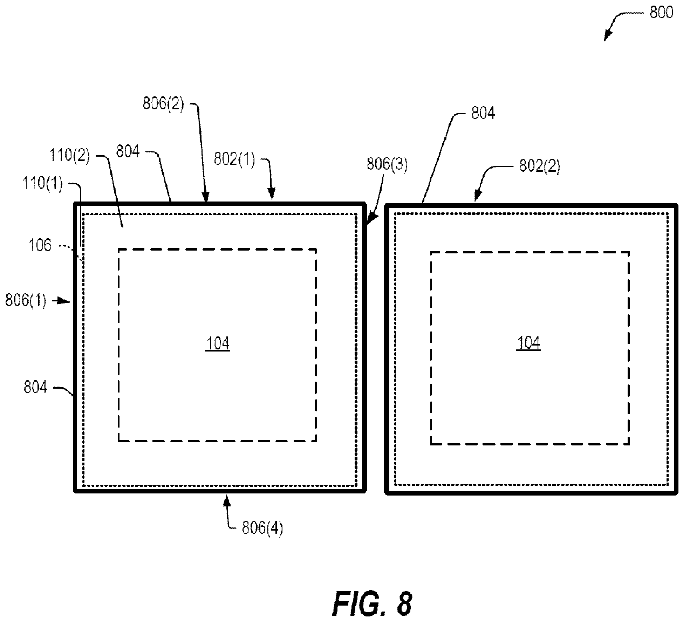

FIG. 8 depicts a top view 800 of a plurality of separated circuit dice 802(1) and 802(2) that include a chip-edge and scribe-lane decoupling capacitor 804, in accordance with one or more embodiments of the present disclosure. The dice 802(1) and 802(2) may be examples of the dice 102(1) and 102(2) in FIGs. 2-7 after the singulation process is completed. Each die 102 or 802 is an electronic device that may be incorporated into or electrically coupled to other circuits.

In this example, the dice 802(1) and 802(2) may each include a MIM capacitor 804 formed from the metal layer 504 (FIG. 5), the dielectric layer 402 (FIGs. 4 and 5), and one or more of the base metallization layer 302 and the semiconductor substrate 202 (FIGs 4-7). Each die 802 may include a first buffer area 110(1), the crack-stop structure 106, and a second buffer area 110(2). Unlike the dice 102(1) and 102(2) in FIG. 1, the dice 802(1) and 802(2) do not include the ionic-contamination barrier structure 108. The MIM capacitors 804 may operate as ionic-contamination seals for the dice 802. In this example, the MIM capacitors 804 may be formed as a die-perimeter extension around the sidewalls 806 and scribe-lane extensions 604 around the bottom extents of the sidewalls 806 of the dice 802(1) and 802(2). In the illustrated example, the electronic device or die 802 includes sidewalls 806(1), 806(2), 806(3), and 806(4), each of which includes a conformal metal layer 504 and a conformal dielectric layer 402 that capacitively couple to one or more of the semiconductor substrate 202 or the base metallization layer 302 to form the MIM capacitor 804. In some implementations, one or more of the sidewalls 806 may include a scribe-lane extension 604 that extends from a base of the sidewall 806 and away from the sidewall 806. The one or more scribe-lane extensions 604 may contribute to an overall capacitance of the MIM capacitor 804.

It should be appreciated that, since the ionic-contamination barrier structure 108 may be omitted (as shown in FIG. 8), the overall size of the die 802 may be reduced by reclaiming (removing) the area previously reserved for the ionic-contamination barrier structure 108 and for the buffer 110(3) (in FIG. 1) between the ionic-contamination barrier structure 108 and the active circuit area 104. Alternatively, the active circuit area 104 (shown in phantom) may be increased without adjusting the size of the die 802.

In a manufacturing environment in which the scribe-lane trenches 312 are formed using lasers or other cutting techniques that don't cause cracking of the die 102, the crack-stop structure 106 (shown in FIG. 8 as a dotted line) may also be omitted, and the metal layer 504 and the dielectric layer 402 may serve as both the crack-stop structure 106 and the ionic-contamination barrier structure 108. In such an embodiment, the size of the die 802 may be reduced accordingly, or the area allocated for the active circuit area 104 may be increased without increasing the size of the die 802.

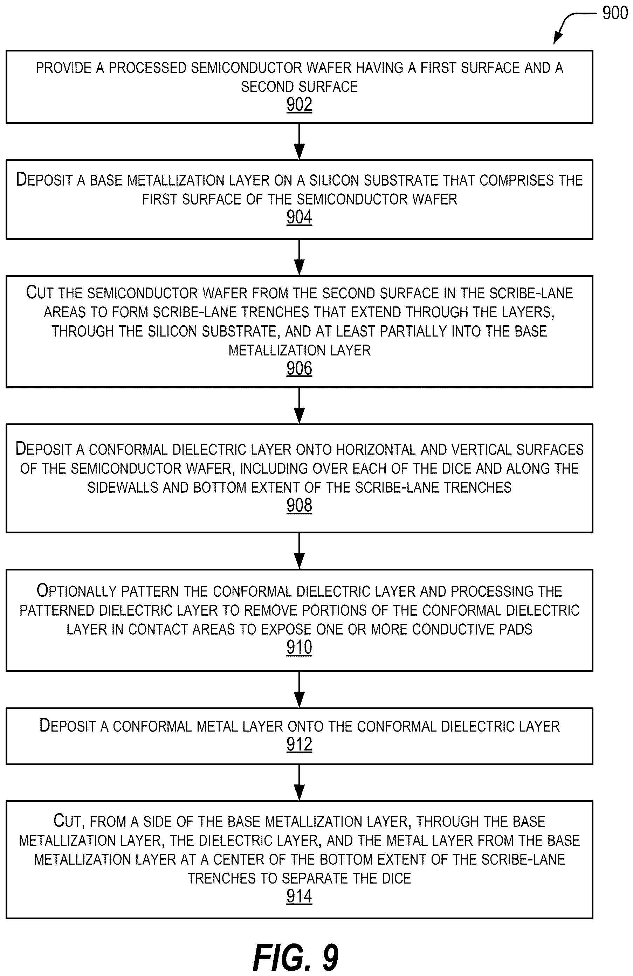

FIG. 9 depicts a flow diagram of a method 900 of forming a semiconductor die including a MIM capacitor, in accordance with one or more embodiments of the present disclosure. At 902, the method 900 may include providing a processed semiconductor wafer 200 having a first surface and a second surface. The semiconductor wafer 200 (in FIG. 2) may include a plurality of pre-singulated dice 102 arranged in an array and separated from one another by scribe-lane areas. Each of the one or more dice 102 may include a plurality of layers 204 forming an active circuit area 104 and optionally one or more of a crack-stop structure 106 or an ionic-contamination barrier structure 108. The processed semiconductor wafer 200 may have been processed using back-grinding. In one or more embodiments, the semiconductor wafer 200 may include conductive pads on a surface of each of the die 102.

At 904, the method 900 may include depositing a base metallization layer 302 on a semiconductor substrate 202 that comprises the first surface 220 of the semiconductor wafer 200. The semiconductor substrate 202 may include a second surface 222 on which the active circuitry 104 may be formed. The base metallization layer 302 (in FIG. 3) may be a base metallization. When each die 102 is subsequently packaged, the metallization layer 302 may be mechanically and electrically coupled to a packaging flange, which may be coupled to electrical ground. The base metallization layer 302 and the semiconductor substrate 202 may form a first conductive plate of a capacitor. The base metallization layer 302 is sometimes referred to as being deposited on a bottom of the die 102.

At 906, the method 900 may include cutting the semiconductor wafer 200 from the second surface in the scribe-lane areas 112 to form scribe-lane trenches 312 (in FIG. 3) that extend through the layers 204, through the semiconductor substrate 202, and at least partially into the base metallization layer 302. The cutting operation may be performed using a saw, a laser, or other cutting process.

At 908, the method 900 may include depositing a conformal dielectric layer 402 onto horizontal and vertical surfaces of the semiconductor wafer 200 over each of the dice 102 and along the sidewalls 702 and bottom extent of the scribe-lane trenches 312. The dielectric layer 402 (in FIG. 4) may be conformal and may cover the interior surfaces (sidewalls 702 and bottom extents) of the scribe-lane trenches 312. This dielectric layer 402 may be formed from a dielectric material that may include one or more of tantalum nitride (TaN), hafnium oxide ($HfO_2$), aluminum oxide ($Al_2O_3$),

doped tantalum pentoxide ($Ta_2O_5$), or other dielectric material that may be configured to enable a capacitance of approximately seventeen (17) femtofarad per micrometer squared ($fF/\mu m^2$) or more. The dielectric layer 402 may form the insulator of the MIM capacitor.

At 910, the method 900 may optionally include patterning the dielectric layer 402 and processing the patterned dielectric layer 402 to remove portions of the dielectric layer 402 in contact areas 502 (in FIG. 5) to expose one or more conductive pads. In one or more embodiments, the dielectric layer 402 may be patterned and processed to expose conductive pads on a surface of the die 102.

At 912, the method 900 may include depositing a conformal metal layer 504 onto the conformal dielectric layer 402. If the dielectric layer 402 was patterned at 910, the metal layer 504 may extend into the contact areas 502 to contact the exposed metal contacts (conductive pad) 508. The metal layer 504 may form a second metal layer of the MIM capacitor.

At 914, the method 900 may include cutting, from a side of the base metallization layer 302, through the base metallization layer 302, through the dielectric layer 402, and through the metal layer 504 from the base metallization layer 302 at a center of a bottom extent of the scribe-lane trenches 312 to separate the dice 102. The cut-through 602 may have a width that is less than a width of the scribe-lane trench 312. In one or more embodiments, the etching, sawing, or laser ablation may be performed at a center of the trench 312. In some embodiments, the cutting operation may remove as little material as possible to leave a scribe-lane extension 604, which may include portions of the metal layer 504, the dielectric layer 402, and the base metallization layer 302.

In one or more embodiments, the metal layer 502, the dielectric layer 402, and one or more of the semiconductor substrate 202 and the base metallization layer 302 may form a MIM capacitor that may be configured to operate as a decoupling capacitor for the chip. The metal layer 504 may be coupled to an operating voltage (VDD) of the chip (for example, through a contact area 502 on a top surface of the die 102), while the semiconductor substrate 202 and the metallization layer 302 may be coupled to ground or to a negative supply voltage (VSS). In some implementations, the metallization layer 302 may be coupled to a conductive feature of the packaging (e.g., to a flange), which may be coupled to ground.

The method 900 may produce a semiconductor die that includes active circuitry and a perimeter structure that may function as an ionic-contamination barrier structure 108, a crack-stop structure 106, or both. In some implementations, the perimeter structure may form a capacitor that can be used to provide decoupling for input/output (I/O) interfaces, power supplies, or other purposes.

In one or more embodiments, the perimeter structure may be used with one or more high-speed interfaces. In one or more embodiments, the perimeter structure manufactured along the sidewalls 806 and the scribe-lane extension 604 may provide a capacitor that may be used for core power supply (0.8V, 1.1V, or other voltage levels) and may remove power-supply noise by shorting high frequency voltage signals to ground.

In one or more embodiments, the perimeter structure may replace internal ionic-contamination barrier structures 108, reducing the overall size of the die 102, enabling a larger active circuit area 104, or both. In some implementations, the perimeter structure may provide the functionality of, and thus enable elimination of one or more of a crack-stop structure 106 or an ionic-contamination barrier structure 108, reducing the overall size of the die 102, enabling a larger active circuit area 104, or both. In some embodiments, the size of the active circuit area 104 may be increased without increasing the size of the die 102. In some embodiments, the size of the active circuit area 104 may be increased while the overall size of the die 102 may be reduced.

In one or more embodiments, a circuit may be produced that may include a capacitor that includes a conformal dielectric layer 402 and a conformal metal layer 504 that are formed on the sidewalls 806 of the die 802. The capacitor may extend around the sidewalls 806 of the die 802 and may include a scribe-lane extension 604. The capacitor may be used as a decoupling capacitor, a power supply filter, or for other purposes.

In one or more embodiments, a method may include applying a base metallization layer 302 to a semiconductor substrate 202 of a semiconductor wafer 200 that includes an array of active circuit areas 104 formed on the semiconductor substrate 202 and separated from one another by scribe-lane areas 112. The method may include cutting the scribe-lane areas 112 of the semiconductor wafer 200 through semiconductor substrate 202 and partially into the base metallization layer 302 to form scribe-lane trenches 312 including one or more sidewalls and depositing a dielectric material 402 onto at least a portion of the semiconductor wafer 200 including the one or more sidewalls within the scribe-lane trenches 312 to form a dielectric layer 402. The method may include depositing a metal material onto the dielectric layer 402 and cutting through the base metallization layer 302 within the scribe-lane trenches 312 to separate the semiconductor wafer 200 into dice 102.

In some embodiments, the metal layer and the dielectric layer may form a perimeter extension that may form a capacitor with one or more of the semiconductor substrate 202 or the base metallization layer 302, where the capacitor extends around a perimeter of each die. In one or more embodiments, each die 102 may include a MIM capacitor extending around the perimeter of the die.

In one or more embodiments, cutting through the base metallization layer 302 may include cutting a center of a bottom extent of each of the scribe-lane trenches 312 to produce one or more scribe-lane extensions 604.

In one or more embodiments, each scribe-lane extension 604 may have a width that is less than half of a width of one of the scribe-lane trenches 312. In one or more embodiments, cutting the center of the bottom extent of each of the scribe-lane trenches 312 may include forming a scribe-lane extension 604 on one or more sidewalls 702 of each of the die 102 of the array of dice 102. Each scribe-lane extension 604 may protrude from one of the one or more sidewalls 702 and may include the base metallization layer 302, the dielectric layer 402, and the metal layer 504.

In one or more embodiments, depositing the dielectric material may include depositing one or more of tantalum nitride (TaN), hafnium oxide (HfO$_2$), aluminum oxide (Al$_2$O$_3$), or doped tantalum pentoxide (Ta$_2$O$_5$). In one or more embodiments, the dielectric material may be selected to enable a capacitance per unit area of seventeen (17) femtofarad per micrometer squared or more. In some embodiments, the dielectric material may be selected to have a resistance that is greater than the semiconductor wafer 202 or the base metallization layer 302.

In one or more embodiments, applying the base metallization layer 302 to the semiconductor substrate 202 may include applying one or more of aluminum, copper, cobalt, nickel, or tungsten to the semiconductor substrate 202 to form the base metallization layer 302. In one or more embodiments, one or more of the metal layer 504 and the dielectric layer 402 provides an ionic contamination barrier structure.

In one or more embodiments, an electronic device may include a semiconductor substrate 202 having a first surface and a second surface. The electronic device may include a base metallization layer formed on the first surface 220 of the semiconductor substrate 202 to form a bottom surface of the electronic device. The electronic device may include one or more circuit layers formed on the second surface 222 of the semiconductor substrate 202, wherein one or more sidewalls extend between the bottom and top surfaces of the electronic device. The electronic device may include a dielectric layer on the one or more sidewalls and may include a metal layer on the dielectric layer.

In one or more embodiments, the one or more circuit layers may include a conductive pad on the top surface, the metal layer may be coupled to the conductive pad through the dielectric layer, and the base metallization layer 302 and the semiconductor substrate 202 may be coupled to one of a negative supply voltage (VSS) or ground and are capacitively coupled to the metal layer 504 through the dielectric layer 402. In one or more embodiments, the metal layer 504 and the dielectric layer 402 may extend around the one or more sidewalls to form a capacitor with one or more of the semiconductor substrate or the base metallization layer. In one or more embodiments, the capacitor is configured to be coupled to an input/output interface to provide a decoupling function. In one or more embodiments, the capacitor is configured to be coupled to a power supply to filter noise from a power supply signal.

In one or more embodiments, the dielectric layer 402 includes one or more of tantalum nitride (TaN), hafnium oxide (HfO$_2$), aluminum oxide (Al$_2$O$_3$), or doped tantalum pentoxide (Ta$_2$O$_5$). In one or more embodiments, the dielectric layer 402 includes a dielectric material selected to enable a capacitance per unit area of seventeen femtofarad per micrometer squared or more. In one or more embodiments, the base metallization layer comprises one or more of aluminum, copper, cobalt, nickel, or tungsten.

In one or more embodiments, the electronic device may include one or more scribe-lane extensions 604 extending from the one or more sidewalls 702. The scribe-lane extension 604 may include the base metallization layer 302, the dielectric layer 402, and the metal layer 504. In one or more embodiments, the scribe-lane extension 604 may have a width that is less than half of a width of a scribe-lane area 112 on a semiconductor wafer 200 from which the die was singulated. In one or more embodiments, one or more of the metal layer 504 or the dielectric layer 402 forms an ionic contamination barrier structure.

In one or more embodiments, an electronic device may include a semiconductor substrate 202 including a first surface 220 and a second surface 222. The electronic device may include a base metallization layer 302 coupled to the first surface 220 of the semiconductor substrate 202. The electronic device may include one or more circuit layers 204 formed on the second surface 222 of the semiconductor substrate to define a top surface of the electronic device, where one or more sidewalls of the electronic device extend between the bottom and top surfaces of the electronic device. The one or more circuit layers may include one or more metal structures forming an active circuit area and including at least one contact pad on a top surface. The electronic device may include a dielectric layer formed on at least a portion of the base metallization layer and on the one or more sidewalls. The dielectric layer may include an open area over the at least one contact pad. The electronic device may include a metal layer 504 formed on the dielectric layer 402 and coupled to the at least one contact pad 508. In one or more embodiments, the metal layer 504, the dielectric layer 402, and one or more of the semiconductor substrate 202 or the base metallization layer 302 may form a capacitor that extends around the one or more sidewalls 702, and the capacitor may include one or more scribe-lane extensions 604 protruding from the one or more sidewalls 702, where each extension includes the metal layer 504, the dielectric layer 402, and the base metallization layer 302. In one or more embodiments, the capacitor may include extensions protruding at an angle that is approximately perpendicular to the sidewalls 702. In some embodiments, each of the scribe-lane extensions 604 may have a width that is less than a half of a width of a scribe-lane area 112 on a semiconductor wafer 200 from which the die 102 was singulated.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

**Claims**

1. A method comprising:

   applying a base metallization layer to a semiconductor substrate of a semiconductor wafer that includes an array of active circuit areas formed on the semiconductor substrate and separated from one another by scribe-lane areas;
   cutting the scribe-lane areas of the semiconductor wafer through the semiconductor substrate and partially into the base metallization layer to form scribe-lane trenches including one or more sidewalls;
   depositing a dielectric material onto at least a portion of the semiconductor wafer including the one or more sidewalls within the scribe-lane trenches to form a dielectric layer;
   depositing a metal layer onto the dielectric layer; and
   cutting through the base metallization layer within the scribe-lane trenches to separate the semiconductor wafer into dice.

2. The method of claim 1, wherein the metal layer and the dielectric layer form a perimeter extension that forms a capacitor with one or more of the semiconductor substrate or the base metallization, wherein the capacitor extends around a perimeter of each die.

3. The method of claim 1 or claim 2, wherein cutting through the base metallization layer comprises cutting a center of a bottom extent of each of the scribe-lane trenches to produce one or more scribe-lane extensions.

4. The method of claim 3, wherein each of the one or more scribe-lane extensions has a width that is less than half of a width of one of the scribe-lane trenches.

5. The method of claim 3, wherein cutting the center of the bottom extent of each of the scribe-lane trenches comprises forming the one or more scribe-lane extensions on one or more sidewalls of each die of the array of dice, each scribe-lane extension protruding from one of the one or more sidewalls and including the base metallization layer, the dielectric layer, and the metal layer.

6. The method according to any preceding claim, wherein depositing the dielectric material comprises depositing one or more of tantalum nitride (TaN), hafnium oxide ($HfO_2$), aluminum oxide ($Al_2O_3$), or doped tantalum pentoxide ($Ta_2O_5$).

7. The method according to any preceding claim, wherein the dielectric material that is selected to enable a capacitance per unit area of seventeen femtofarad per micrometer squared or more.

8. The method according to any preceding claim, wherein applying the base metallization layer to the semiconductor substrate comprises applying one or more of aluminum, copper, cobalt, nickel, or tungsten to the semiconductor substrate to form the base metallization layer.

9. The method according to any preceding claim, wherein one or more of the metal layers and the dielectric layer provides an ionic-contamination barrier structure.

10. An electronic device comprising:

a semiconductor substrate having a first surface and a second surface;
a base metallization layer formed on the first surface of the semiconductor substrate to form a bottom surface of the electronic device;
one or more circuit layers formed on the second surface of the semiconductor substrate to define a top surface of the electronic device, wherein one or more sidewalls extend between the bottom and top surfaces of the electronic device;
a dielectric layer on the one or more sidewalls; and
a metal layer on the dielectric layer.

11. The electronic device of claim 10, wherein:

the one or more circuit layers includes a conductive pad on the top surface;
the metal layer is coupled to the conductive pad through the dielectric layer; and
the base metallization layer and the semiconductor substrate are configured to be coupled to one of a negative supply voltage (VSS) or ground and are capacitively coupled to the metal layer through the dielectric layer.

12. The electronic device of claim 10 or claim 11, wherein the metal layer and the dielectric layer extend around the one or more sidewalls to form a capacitor with one or more of the semiconductor substrate or the base metallization layer.

13. The electronic device of claim 12, wherein the capacitor is configured to be coupled to an input/output interface to provide a decoupling function.

14. The electronic device of claim 12, wherein the capacitor is configured to be coupled to a power supply to filter noise from a power supply signal.

15. The electronic device of claim 10 to claim 14, wherein one or more of the metal layers or the dielectric layer forms an ionic-contamination barrier structure.

**FIG. 1**

Die 2
102(2)

Die 1
102(1)

112

104

200

108

106

106

108

208(4)

208(3)

208(2)

208(1)

212(4)
210(4)
206(4)

212(3)
210(3)
206(3)

212(2)
210(2)
206(2)

212(1)

206(1)

210(1)

218(4)

218(3)

218(2)

218(1)

216(4)

204

216(2)

222

202

220

**FIG. 2**

300

Die 2
102(2)

Die 1
102(1)

312

108

106

106

108

104

200

208(4)

218(4)

212(4)
210(4)
206(4)

204

208(3)

218(3)

212(3)
210(3)
206(3)

208(2)

218(2)

212(2)
210(2)
206(2)

216

208(1)

218(1)

212(1)

222

206(1)

210(1)

202

202

302

220

**FIG. 3**

**FIG. 4**

**FIG. 5**

FIG. 6

FIG. 7

FIG. 8

— 900

PROVIDE A PROCESSED SEMICONDUCTOR WAFER HAVING A FIRST SURFACE AND A SECOND SURFACE
902

DEPOSIT A BASE METALLIZATION LAYER ON A SILICON SUBSTRATE THAT COMPRISES THE FIRST SURFACE OF THE SEMICONDUCTOR WAFER
904

CUT THE SEMICONDUCTOR WAFER FROM THE SECOND SURFACE IN THE SCRIBE-LANE AREAS TO FORM SCRIBE-LANE TRENCHES THAT EXTEND THROUGH THE LAYERS, THROUGH THE SILICON SUBSTRATE, AND AT LEAST PARTIALLY INTO THE BASE METALLIZATION LAYER
906

DEPOSIT A CONFORMAL DIELECTRIC LAYER ONTO HORIZONTAL AND VERTICAL SURFACES OF THE SEMICONDUCTOR WAFER, INCLUDING OVER EACH OF THE DICE AND ALONG THE SIDEWALLS AND BOTTOM EXTENT OF THE SCRIBE-LANE TRENCHES
908

OPTIONALLY PATTERN THE CONFORMAL DIELECTRIC LAYER AND PROCESSING THE PATTERNED DIELECTRIC LAYER TO REMOVE PORTIONS OF THE CONFORMAL DIELECTRIC LAYER IN CONTACT AREAS TO EXPOSE ONE OR MORE CONDUCTIVE PADS
910

DEPOSIT A CONFORMAL METAL LAYER ONTO THE CONFORMAL DIELECTRIC LAYER
912

CUT, FROM A SIDE OF THE BASE METALLIZATION LAYER, THROUGH THE BASE METALLIZATION LAYER, THE DIELECTRIC LAYER, AND THE METAL LAYER FROM THE BASE METALLIZATION LAYER AT A CENTER OF THE BOTTOM EXTENT OF THE SCRIBE-LANE TRENCHES TO SEPARATE THE DICE
914

*FIG. 9*

Europäisches
Patentamt

European
Patent Office

Office européen
des brevets

# EUROPEAN SEARCH REPORT

**Application Number**

EP 25 15 1894

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2015/200146 A1 (REBER DOUGLAS M [US] ET AL) 16 July 2015 (2015-07-16) * abstract *; claims; figures 10,11 * | 1-15 | INV. H01L23/522 H01L21/78 H10D1/68 |
| Y | CN 114 783 948 A (FENGFEIXIN SHANGHAI TECH CO LTD) 22 July 2022 (2022-07-22) * abstract *; claims; figures 1-15 * | 1-15 | |
| Y | US 2023/059848 A1 (SUMMERFELT SCOTT ROBERT [US] ET AL) 23 February 2023 (2023-02-23) * abstract *; claims; figures 4B,5-22 * * paragraphs [0035], [0058] * | 1-15 | |
| Y | US 2012/241914 A1 (YOOK HYUNG SUN [MY] ET AL) 27 September 2012 (2012-09-27) * abstract *; claims; figure 6 * * paragraphs [0012], [0030] * | 9,15 | |
| Y | CN 115 376 905 A (SHANDONG ZHONGQING INTELLIGENT TECH CO LTD) 22 November 2022 (2022-11-22) * paragraph [0030] * | 6,7 | TECHNICAL FIELDS SEARCHED (IPC) H01L H10D |
| Y | WO 2023/070952 A1 (CHANGXIN MEMORY TECH INC [CN]) 4 May 2023 (2023-05-04) * page 6, lines 22-26 * | 6,7 | |
| A | US 2023/067386 A1 (CHOI MINJUNG [KR] ET AL) 2 March 2023 (2023-03-02) * abstract *; claims; figures 2A,2B * | 1-15 | |
| A | US 8 624 348 B2 (MOHAMMED ILYAS [US]; INVENSAS CORP [US]) 7 January 2014 (2014-01-07) * abstract *; claims; figures 7-9 * | 1-15 | |

-/--

The present search report has been drawn up for all claims

| Place of search | Date of completion of the search | Examiner |
|---|---|---|
| The Hague | 30 June 2025 | Wirner, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

Europäisches
Patentamt

European
Patent Office

Office européen
des brevets

**EUROPEAN SEARCH REPORT**

**Application Number**

EP 25 15 1894

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,P | CN 118 431 161 A (XINMING SEMICONDUCTOR HANGZHOU CO LTD) 2 August 2024 (2024-08-02) * abstract *; claims; figures * * paragraph [0035] * | 1-15 | |

-----

**TECHNICAL FIELDS SEARCHED (IPC)**

The present search report has been drawn up for all claims

| Place of search | Date of completion of the search | Examiner |
|---|---|---|
| The Hague | 30 June 2025 | Wirner, Christoph |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 .................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 15 1894

This annex lists the patent family members relating to the patent documents cited in the above-mentioned European search report.
The members are as contained in the European Patent Office EDP file on
The European Patent Office is in no way liable for these particulars which are merely given for the purpose of information.

30-06-2025

| Patent document cited in search report | Publication date | Patent family member(s) | Publication date |
|---|---|---|---|
| US 2015200146 A1 | 16-07-2015 | NONE | |
| CN 114783948 A | 22-07-2022 | NONE | |
| US 2023059848 A1 | 23-02-2023 | CN 117616558 A<br>EP 4388586 A1<br>US 2023059848 A1<br>WO 2023023052 A1 | 27-02-2024<br>26-06-2024<br>23-02-2023<br>23-02-2023 |
| US 2012241914 A1 | 27-09-2012 | US 2012241914 A1<br>WO 2011027193 A1 | 27-09-2012<br>10-03-2011 |
| CN 115376905 A | 22-11-2022 | NONE | |
| WO 2023070952 A1 | 04-05-2023 | CN 116056555 A<br>WO 2023070952 A1 | 02-05-2023<br>04-05-2023 |
| US 2023067386 A1 | 02-03-2023 | CN 115910991 A<br>KR 20230031712 A<br>US 2023067386 A1<br>US 2025157948 A1 | 04-04-2023<br>07-03-2023<br>02-03-2023<br>15-05-2025 |
| US 8624348 B2 | 07-01-2014 | US 2013119520 A1<br>US 2014141597 A1 | 16-05-2013<br>22-05-2014 |
| CN 118431161 A | 02-08-2024 | NONE | |

EPO FORM P0459

For more details about this annex : see Official Journal of the European Patent Office, No. 12/82